# EUROPEAN PATENT APPLICATION

(11) **EP 4 262 330 A1**
(43) Date of publication of application: **18.10.2023**
(21) Application number: 21905551.4
(22) Date of filing: 03.12.2021
(51) Int. Cl.: H05K 3/22

(54) **SECONDARY DRILLING PROCESS**

(30) Priority: 14.12.2020 CN 202011474637
(71) Applicant: Huawei Technologies Co., Ltd., Shenzhen, Guangdong 518129 (CN)
(72) Inventor: GONG, Lili, Shenzhen, Guangdong 518129 (CN); XIE, Ertang, Shenzhen, Guangdong 518129 (CN); GAO, Feng, Shenzhen, Guangdong 518129 (CN); YANG, Dongcheng, Shenzhen, Guangdong 518129 (CN)
(74) Representative: Gill Jennings & Every LLP
(86) International application number: PCT/CN2021/135425
(87) International publication number: WO 2022/127622

(57) **Abstract**

This application provides a secondary drilling process. The secondary drilling process is implemented by a drilling device. The drilling device includes an image acquisition apparatus, a controller, and a drilling machine. The controller is separately signally connected to the image acquisition apparatus and the drilling machine. A surface of a structure to be secondarily drilled on which secondary drilling needs to be performed has a target, and the secondary drilling process specifically includes: The controller determines, based on the target of the structure to be secondarily drilled, a position of a region to be secondarily drilled of the structure to be secondarily drilled by the image acquisition apparatus; the controller then controls the image acquisition apparatus to generate an image for topography of the region to be secondarily drilled; the controller obtains the image, and obtains actual hole position coordinates of a primary drilled hole needing to be secondarily drilled based on the image; and the controller controls, based on the actual hole position coordinates, a main shaft of the drilling machine to perform secondary drilling on the primary drilled hole needing to be secondarily drilled of the structure to be secondarily drilled. This solution can ensure high alignment precision between a hole formed by the secondary drilling and the primary drilled hole, thereby improving product quality.

## Description

### CROSS-REFERENCE TO RELATED APPLICATIONS

This application claims priority to Chinese Patent Application No. 202011474637.6, filed with the China National Intellectual Property Administration on December 14, 2020 and entitled "SECONDARY DRILLING PROCESS", which is incorporated herein by reference in its entirety.

### TECHNICAL FIELD

This application relates to the field of electronic device technologies, and in particular, to a secondary drilling process.

### BACKGROUND

With development of science and technologies, electronic devices have more and more functions and tend to be miniaturized. Therefore, a single sided circuit board or a double sided circuit board cannot meet a requirement. Therefore, multilayer circuit boards are increasingly applied to the electronic devices, and multilayer lines also need to be disposed inside the circuit boards to implement miniaturization of the circuit boards. In a process of preparing a multilayer circuit board, single-layer boards with a circuit pattern may be prepared first, and then the single-layer boards are stacked to form the multilayer circuit board. To implement current conduction between the single-layer boards, first drilling needs to be performed on the stacked multilayer circuit board to make a conductive through hole, namely, a primary drilled hole. However, there may be a redundant conductive layer in the primary drilled hole, which leads to connection of circuits that do not need to be connected. In addition, there may also be a redundant STUB (STUB) structure, which affects transmission performance of signals. Therefore, secondary drilling, namely, back drilling, needs to be performed on the primary drilled hole, to remove the redundant conductive layer and the STUB in the primary drilled hole.

To ensure coaxiality between a back drilled hole formed by back drilling and the primary drilled hole is an important factor to ensure quality of the multilayer board. In conventional technologies, to implement alignment between the back drilled hole and the primary drilled hole, a pin is usually used to position the multilayer circuit board, a target of a back drill region is used to determine the back drill region, and an expansion and contraction ratio of each back drill region is measured. Based on the expansion and contraction ratio and original position information of the primary drilled hole, a position of a current primary drilled hole is estimated, and then back drilling is performed on the estimated position of the primary drilled hole to form the back drilled hole. In this solution, the primary drilled hole is obtained by calculation through the original position information and the expansion and contraction ratio. However, actual expansion and contraction of the back drill region may be uneven, in other words, there is a deviation in the expansion and contraction ratio. In addition, the primary drilled hole is a primary drilled hole made on the multilayer circuit board based on the original position information, and there is also a deviation between an actual position of the primary drilled hole and a position of the primary drilled hole in the original position information, resulting in a large deviation between the estimated position of the primary drilled hole and the actual position of the primary drilled hole, and a large alignment deviation between the back drilled hole and the primary drilled hole.

### SUMMARY

This application provides a secondary drilling process, to improve alignment precision between a hole formed by secondary drilling and a primary drilled hole, and improve product quality.

This application provides a secondary drilling process, for example, a back drilling process of a circuit board. The secondary drilling process is for a scenario in which secondary drilling is performed on a position of a primary drilled hole for a structure to be secondarily drilled that already has the primary drilled hole. The secondary drilling process is implemented by a drilling device. The drilling device includes an image acquisition apparatus, a controller, and a drilling machine. The controller is separately signally connected to the image acquisition apparatus and the drilling machine, so that the controller can be configured to control the drilling machine to perform secondary drilling on the structure to be secondarily drilled based on information obtained by the image acquisition apparatus. A surface of the structure to be secondarily drilled on which secondary drilling needs to be performed has a target, and the secondary drilling process specifically includes: The controller determines, based on the target of the structure to be secondarily drilled, a position of a region to be secondarily drilled of the structure to be secondarily drilled by the image acquisition apparatus; the controller then controls the image acquisition apparatus to generate an image for topography of the region to be secondarily drilled; the controller obtains the image, and obtains actual hole position coordinates of a primary drilled hole needing to be secondarily drilled based on the image; and the controller controls, based on the actual hole position coordinates, a main shaft of the drilling machine to perform secondary drilling on the primary drilled hole needing to be secondarily drilled of the structure to be secondarily drilled. In this solution, a secondary drilling device obtains an actual position of the primary drilled hole, and then performs secondary drilling on the actual position of the primary drilled hole, so that alignment precision between a hole formed by secondary drilling and the primary drilled hole can be ensured, and product quality can be improved.

A specific type of the image acquisition apparatus is not limited. For example, the image acquisition apparatus may be a lens, and obtains the image for the topography of the region to be secondarily drilled in a manner of photographing. Alternatively, the image acquisition apparatus may be a two-dimensional scanner, and obtains the image for the topography of the region to be secondarily drilled in a manner of scanning.

The target includes an edge target and a target of the region to be secondarily drilled, where the edge target is located at an edge of the structure to be secondarily drilled, and the target of the region to be secondarily drilled is located on a peripheral side of the region to be secondarily drilled. The edge target is for determining a position of the structure to be secondarily drilled, and the target of the region to be secondarily drilled is for determining the position of the region to be secondarily drilled.

In a specific embodiment, in the secondary drilling process in the technical solution of this application, before the controller determines, based on the target of the structure to be secondarily drilled, a position of a region to be secondarily drilled of the structure to be secondarily drilled by the image acquisition apparatus, the process further includes: preparing the target on the structure to be secondarily drilled; or defining the target on the structure to be secondarily drilled, that is, defining the target by using a structure of the structure to be secondarily drilled, thereby simplifying a procedure of the secondary drilling process.

The image acquisition apparatus and the controller may be disposed on the drilling machine, to obtain the actual hole position coordinates of the primary drilled hole needing to be secondarily drilled in an online manner. Specifically, the structure to be secondarily drilled may be first mounted on a workbench of the drilling machine, and the controller obtains the actual hole position coordinates of the primary drilled hole needing to be secondarily drilled by the image acquisition apparatus, to control the drilling machine to perform secondary drilling on the structure to be secondarily drilled. In this solution, a structure of the drilling device is simple and a control process is simple.

Alternatively, obtaining of the image for the topography of the region to be secondarily drilled may be completed offline, in other words, before the structure to be secondarily drilled is mounted on the workbench of the drilling machine, the image for the topography of the region to be secondarily drilled has been obtained by the image acquisition apparatus. Specifically, the drilling device further includes an offline measuring machine, and the controller includes a first control unit and a second control unit. The first control unit and the image acquisition apparatus are disposed on the offline measuring machine, and the first control unit is signally connected to the image acquisition apparatus, and is configured to control the image acquisition apparatus to obtain the image for the topography of the region to be secondarily drilled. The second control unit is disposed on the drilling machine, and the second control unit is signally connected to the drilling machine, to control the drilling machine to perform secondary drilling on the primary drilled hole in the region to be secondarily drilled.

For specific implementation of the foregoing offline measurement process, the offline measuring machine may be first used to generate the image only for the topography of the region to be secondarily drilled, and then the second control unit analyzes the image, and controls the drilling machine to perform secondary drilling based on the image. Specifically, the first control unit may determine, based on the target of the structure to be secondarily drilled, the region to be secondarily drilled of the structure to be secondarily drilled by the image acquisition apparatus; the first control unit controls the image acquisition apparatus to generate the image for the topography of the region to be secondarily drilled; and the first control unit associates the image with traceability information of the corresponding structure to be secondarily drilled. Then, mount the structure to be secondarily drilled with traceability information on a workbench of the drilling machine. The second control unit disposed on the drilling machine reads the traceability information, and can obtain the image corresponding to the current structure to be secondarily drilled through the traceability information; the second control unit obtains, based on the image, system hole position coordinates of the primary drilled hole needing to be secondarily drilled in the drilling machine, in other words, the second control unit calculates, based on the image, the system hole position coordinates of the primary drilled hole needing to be secondarily drilled in the drilling machine; and the second control unit may further control, based on the system hole position coordinates, the main shaft of the drilling machine to perform secondary drilling on the primary drilled hole needing to be secondarily drilled of the structure to be secondarily drilled. In this solution, the topography of the region to be secondarily drilled may be obtained offline to generate the image, thereby helping improve secondary drilling efficiency of the drilling machine.

In another technical solution, the actual hole position coordinates of the primary drilled hole needing to be secondarily drilled in the structure to be secondarily drilled may also be obtained by the offline measuring machine, to further improve the secondary drilling efficiency. Specifically, the first control unit determines, based on the target of the structure to be secondarily drilled, the region to be secondarily drilled of the structure to be secondarily drilled by the image acquisition apparatus; the first control unit controls the image acquisition apparatus to generate the image for the topography of the region to be secondarily drilled; and in addition, the first control unit may further obtain the actual hole position coordinate of the primary drilled hole needing to be secondarily drilled on the structure to be secondarily drilled based on the image, and associate the actual hole position coordinate with traceability information of the corresponding structure to be secondarily drilled; Then, mount the structure to be secondarily drilled on a workbench of the drilling machine. The second control unit reads the traceability information, and directly obtains the actual hole position coordinates; the second control unit maps the actual hole position coordinates to system hole position coordinates of the primary drilled hole needing to be secondarily drilled in the drilling machine; and the second control unit controls, based on the system hole position coordinates, the main shaft of the drilling machine to perform secondary drilling on the primary drilled hole needing to be secondarily drilled of the structure to be secondarily drilled. In this solution, more processes are completed in the offline measuring machine, thereby helping further improve the efficiency of drilling machine.

A specific type of the traceability information is not limited, and may be a bar code, a two-dimensional code, or number information. This is not limited in this application, and may be selected based on an actual drilling device, provided that information can be transferred.

The secondary drilling process may be specifically applied to a back drilling process of a circuit board. A structure to be secondarily drilled is a circuit board, and the secondary drilling process is a back drilling process. Therefore, alignment precision between a back drilled hole and a primary drilled hole can be improved, wiring density of the circuit board can be improved, and quality of the circuit board can be improved.

### BRIEF DESCRIPTION OF DRAWINGS

FIG. 1 is a schematic diagram of a structure of back drilling of a circuit board;
FIG. 2 is a diagram of a structure of a deviation in secondary drilling;
FIG. 3 is another diagram of a structure of a deviation in secondary drilling;
FIG. 4 is a reference diagram of board positioning in a secondary drilling process in conventional technologies;
FIG. 5 is a flowchart of a secondary drilling process according to an embodiment of this application;
FIG. 6 is a flowchart of a structure of secondary drilling according to an embodiment of this application;
FIG. 7 is another flowchart of a secondary drilling process according to an embodiment of this application;
FIG. 8 is another flowchart of a structure of secondary drilling according to an embodiment of this application;
FIG. 9 is another flowchart of a secondary drilling process according to an embodiment of this application; and
FIG. 10 is another flowchart of a structure of secondary drilling according to an embodiment of this application.

**REFERENCE NUMERALS**

| | | | |
|---|---|---|---|
| 10- | Drill bit; | 20- | Main shaft; |
| 1- | Circuit board; | 11- | Structure to be secondarily drilled; |
| 12- | Traceability information; | 2- | Primary drilled hole; |
| 3- | Conductive layer; | 4- | Hole ring; |
| 5- | Inner transmission line; | 6- | Pin; |
| 7- | Region to be secondarily drilled; | 8- | Target; |
| 81- | Edge target; | 82- | Target of the region to be secondarily drilled; |
| and | | | |
| 9- | Image acquisition apparatus. | | |

### DESCRIPTION OF EMBODIMENTS

Terms used in the following embodiments are merely intended to describe specific embodiments, but are not intended to limit this application. As used in the specification and the appended claims of this application, singular expressions including "one", "one type", "said", "foregoing", "the" and "this" are also intended to include such expressions as "one or more", unless the context clearly indicates to the contrary.

Reference to "an embodiment" or "a specific embodiment" or the like described in this specification means that one or more embodiments of this application include a specific feature, structure, or feature described with reference to the embodiment. The terms "comprise", "include", "have", and variations thereof all mean "including, but not limited to", unless otherwise specified.

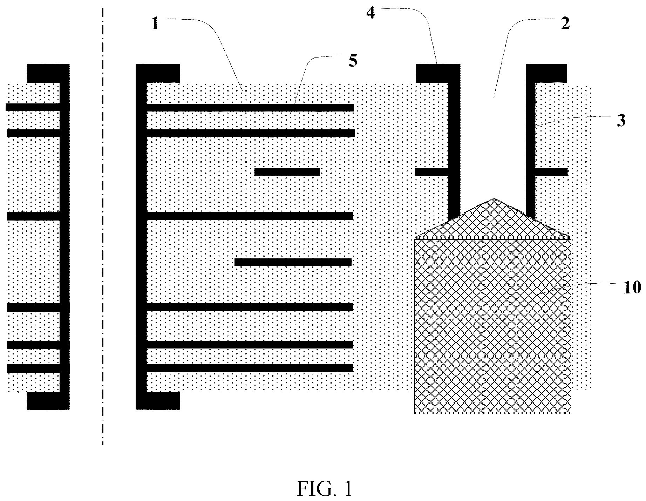

To facilitate understanding of a secondary drilling process provided in embodiments of this application, the following first describes an application scenario of the secondary drilling process. In a processing process, particularly in a processing process of a circuit board in an electronic device, a drilling process is often required, and secondary drilling needs to be performed on based on a primary drilled hole that has been drilled, to ream a hole or remove a part of a structure of the hole. By using back drilling of a multilayer board as an example, back drilling refers to performing secondary drilling based on the primary drilled hole on the board. FIG. 1 is a schematic diagram of a back drilling process of a circuit board. As shown in the figure, a circuit board 1 already has a primary drilled hole 2, and the primary drilled hole 2 has a conductive layer 3 inside. A drill bit 10 performs secondary drilling, namely, back drilling, on the primary drilled hole 2. For ease of description, back drilling is collectively referred to as secondary drilling below. In an ideal state, a central axis of a hole formed by secondary drilling overlaps a central axis of the primary drilled hole 2, to ensure quality of the circuit board 1 after the second drilling. For example, the conductive layer 3 in the primary drilled hole 2 is retained to a required length, to reduce signal loss and remove a hole ring 4 on a surface of the circuit board 1. In addition, the circuit board 1 has an inner transmission line 5 inside, to control a distance from a hole wall to the inner transmission line 5 of the circuit board after the secondary drilling. Precision of the secondary drilling directly affects an aperture design of the secondary drilling and a spacing design between through holes when the circuit board is designed with high density, thereby helping improve wiring density of the circuit board.

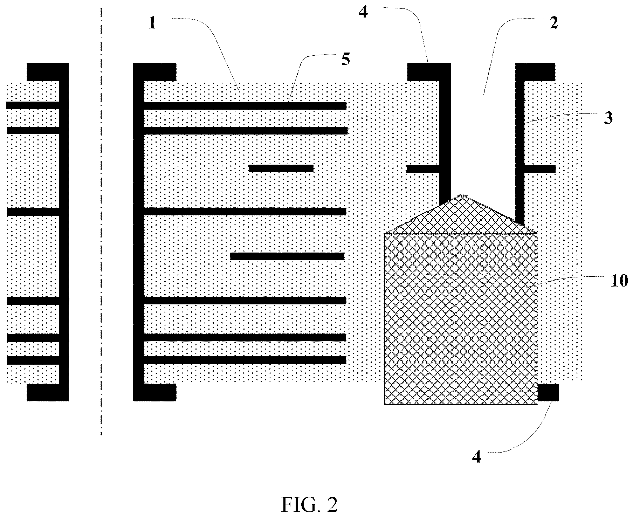

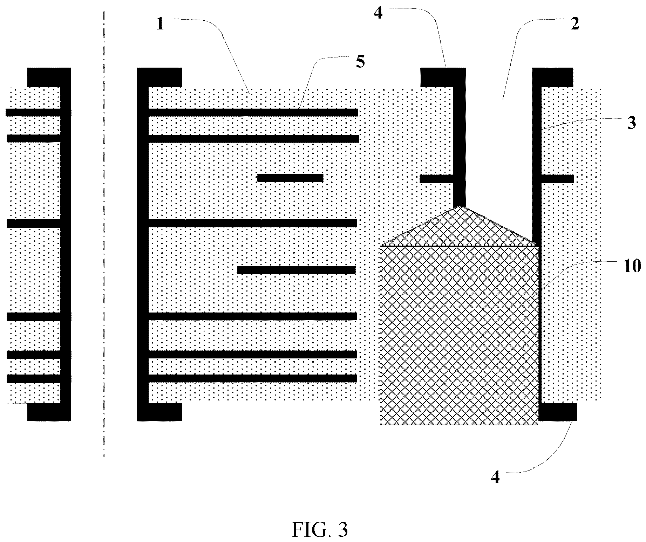

FIG. 2 and FIG. 3 are respectively diagrams of consequences of deviations in secondary drilling. As shown in FIG. 2, after a deviation of the secondary drilling relative to the primary drilled hole 2, a residual hole ring 4 on the surface of the circuit board 1 may be caused. The residual hole ring 4 has poor adhesion and is easy to fall off, which may cause a problem that a short circuit occurs on the circuit board 1. As shown in FIG. 3, when a deviation of the secondary drilling relative to the primary drilled hole 2 is relatively serious, a residual conductive layer 3 in the primary drilled hole 2 may also be caused, resulting in damage of a transmitted signal. In addition, the secondary drilling may drill into an adjacent inner layer transmission line 5, affecting integrity of the inner layer transmission line 5.

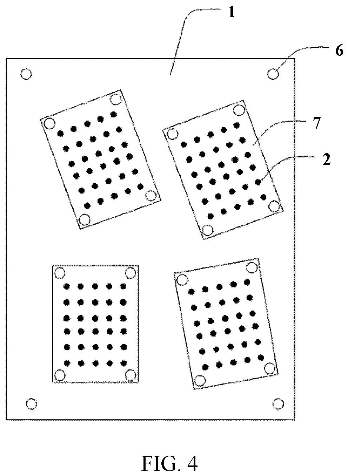

FIG. 4 is a reference diagram of board positioning in a secondary drilling process in conventional technologies. As shown in FIG. 4, in the conventional technologies, a pin is used on a peripheral side of a circuit board 1 to fix the circuit board 1 at a set position, and the circuit board 1 is divided into multiple regions 7 to be secondarily drilled. Each region 7 to be secondarily drilled has a target 8. After the region 7 to be secondarily drilled is determined based on the target 8, an expansion and contraction ratio of each region 7 to be secondarily drilled is measured, and a position of a primary drilled hole 2 is calculated based on the expansion and contraction ratio and an original position of the primary drilled hole 2. Then, secondary drilling is performed based on the calculated position of the primary drilled hole 2. In this solution, if a deviation occurs during preparation of the primary drilled hole 2, a deviation may also occur between the calculated position of the primary drilled hole 2 and an actual position of the primary drilled hole 2. In addition, there may be an uneven expansion and contraction ratio in the regions 7 to be secondarily drilled. Therefore, a deviation may occur between the calculated position of the primary drilled hole 2 and the actual position of the primary drilled hole 2, resulting in a large deviation between a central axis of a hole formed by secondary drilling and a central axis of the primary drilled hole 2.

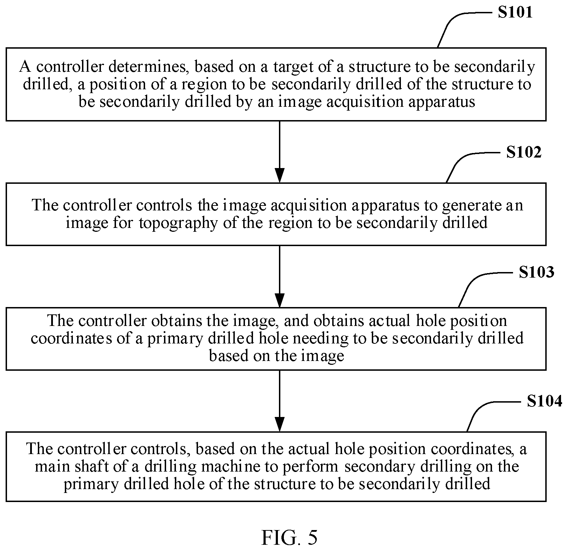

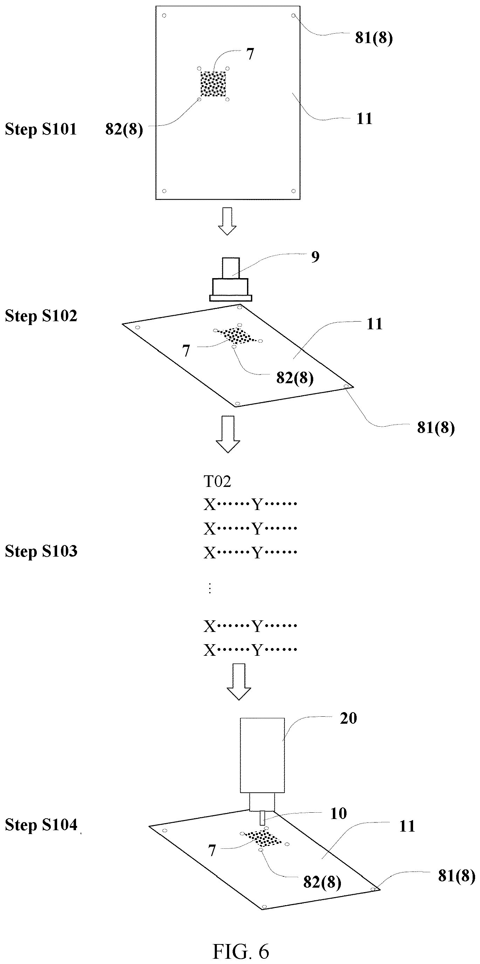

To reduce the deviation between the central axis of the hole formed by secondary drilling and the central axis of the primary drilled hole and improve product quality, this application provides a secondary drilling process. Specifically, the secondary drilling process is implemented by a drilling device. The drilling device includes an image acquisition apparatus, a controller, and a drilling machine. The controller is separately signally connected to the image acquisition apparatus and the drilling machine. FIG. 5 is a flowchart of a secondary drilling process according to an embodiment of this application. FIG. 6 is a flowchart of a structure of secondary drilling according to an embodiment of this application. As shown in FIG. 5 and FIG. 6, a procedure of the secondary drilling process includes the following steps.

Step S 101: A controller determines, based on a target 8 of a structure 11 to be secondarily drilled, a position of a region 7 to be secondarily drilled of the structure 11 to be secondarily drilled by an image acquisition apparatus 9.

Specifically, the target 8 may be a mark with a set shape, and includes an edge target 81 located at an edge of the structure 11 to be secondarily drilled and a target 82 of the region to be secondarily drilled located at a peripheral side of the region 7 to be secondarily drilled, to facilitate identifying a position of the structure 11 to be secondarily drilled and the position of the region 7 to be secondarily drilled. The controller stores information about the target 8 and theoretical information about a primary drilled hole needing to be secondarily drilled. The controller may identify a position of the target 8 based on the image acquisition apparatus 9, and may further determine the position of the region 7 to be secondarily drilled of the structure 11 to be secondarily drilled.

A manner of forming the foregoing target is not limited in this application. Before step S101, the process may further include: preparing the target 8 on the structure 11 to be secondarily drilled; or defining the target 8 on the structure 11 to be secondarily drilled, that is, defining the target 8 by using a structure of the structure 11 to be secondarily drilled, thereby simplifying a procedure of the secondary drilling process.

Step S102: The controller controls the image acquisition apparatus 9 to generate an image for topography of the region 7 to be secondarily drilled.

The controller may control the image acquisition apparatus 9 to form the image for the topography of the region 7 to be secondarily drilled after obtaining the position of region 7 to be secondarily drilled, where the image acquisition apparatus 9 may be a lens or may be a two-dimensional scanner. The lens takes a photo on the region 7 to be secondarily drilled, to obtain the image for the topography of the region 7 to be secondarily drilled. The two-dimensional scanner scans the region 7 to be secondarily drilled, to obtain the image for the topography of the region 7 to be secondarily drilled.

Step S103: The controller obtains the image, and obtains actual hole position coordinates of a primary drilled hole needing to be secondarily drilled based on the image.

The foregoing image includes a pattern of the primary drilled hole, and the controller may obtain the actual hole position coordinates of the primary drilled hole needing to be secondarily drilled through calibration and calculation with reference to the theoretical information about the primary drilled hole needing to be secondarily drilled stored in the controller.

Step S104: The controller controls, based on the actual hole position coordinates, a main shaft 20 of the drilling machine to perform secondary drilling on the primary drilled hole of the structure 11 to be secondarily drilled.

After obtaining the actual hole position coordinates, the controller may control the main shaft 20 to move to a position of the primary drilled hole based on the actual hole position coordinates. A drill bit 10 is mounted on the main shaft 20, and the drill bit 10 specifically performs secondary drilling on the primary drilled hole.

In this solution, the image acquisition apparatus 9 is used to generate the image of the region 7 to be secondarily drilled of the structure 11 to be secondarily drilled, and perform analysis processing on the image, to obtain the actual hole position coordinates of the primary drilled hole needing to be secondarily drilled of the structure 11 to be secondarily drilled. Therefore, this solution may obtain an actual position of the primary drilled hole, and the drilling machine performs secondary drilling on the actual position of the primary drilled hole. Because the actual position of the primary drilled hole is directly obtained, this application helps reduce a deviation between a central axis of a hole formed by secondary drilling and a central axis of the primary drilled hole and improve alignment precision between the hole formed by secondary drilling and the primary drilled hole, thereby improving product quality. In this solution, when the image acquisition apparatus 9 is specifically applied, a field of view range of the image acquisition apparatus 9 may be adjusted based on a size of the region 7 to be secondarily drilled, so that the secondary drilling region 7 is entirely within the field of view range of the image acquisition apparatus 9, thereby helping improve image acquisition efficiency.

When the foregoing solution is specifically implemented, the image for the topography of the region 7 to be secondarily drilled may be obtained in an online manner, or the image for the topography of the region 7 to be secondarily drilled may be obtained in an offline manner. When the online manner is used, the foregoing image acquisition apparatus 9 and the controller are both located on the drilling machine. When the foregoing secondary drilling process is implemented, before step S101, the structure 11 to be secondarily drilled is first mounted on a workbench of the drilling machine, so that the secondary drilling process is directly completed on a drilling device of the drilling machine, and a control process is simple.

When the image for the topography of region 7 to be secondarily drilled is obtained in the offline manner, the drilling device further includes an offline measuring machine, and the controller includes a first control unit and a second control unit. Specifically, the first control unit is signally connected to the image acquisition apparatus 9, and the first control unit and the image acquisition apparatus 9 are disposed on the foregoing offline measuring machine, and are configured to obtain the image for the topography of the region 7 to be secondarily drilled in the offline manner, to obtain the actual position of the primary drilled hole. The second control unit is signally connected to the drilling machine, and the second control unit is disposed on the drilling machine, so that the drilling machine can perform secondary drilling on the position of the primary drilled hole under the control of the second control unit. In this solution, the image for the topography of the region 7 to be secondarily drilled is obtained in the offline manner, so that time consumed by the drilling machine in the secondary drilling process can be reduced, and work efficiency can be improved.

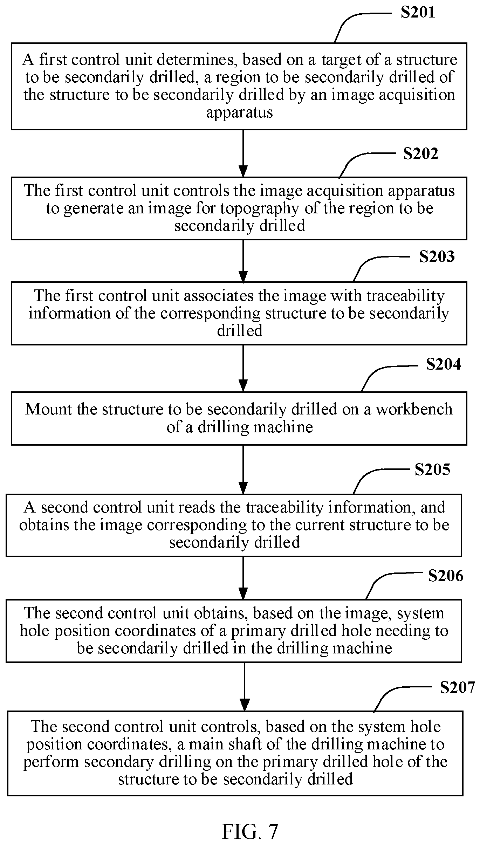

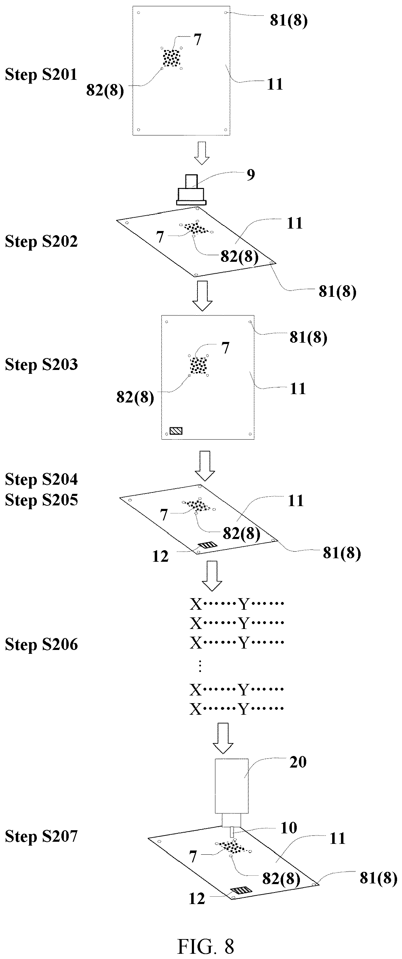

FIG. 7 is another flowchart of a secondary drilling process according to an embodiment of this application. FIG. 8 is another flowchart of a structure of secondary drilling according to an embodiment of this application. As shown in FIG. 7 and FIG. 8, a procedure of the secondary drilling process includes the following steps.

Step S201: A first control unit determines, based on a target 8 of a structure 11 to be secondarily drilled, a region 7 to be secondarily drilled of the structure 11 to be secondarily drilled by an image acquisition apparatus 9.

Step S202: The first control unit controls the image acquisition apparatus 9 to generate an image for topography of the region 7 to be secondarily drilled.

Step S203: The first control unit associates the image with traceability information 12 of the corresponding structure 11 to be secondarily drilled.

In this solution, an offline measuring machine is first used to obtain the image for the topography of the region 7 to be secondarily drilled of the structure 11 to be secondarily drilled, and then the image is associated with the traceability information 12 of the structure 11 to be secondarily drilled. After reading the traceability information 12 of the structure 11 to be secondarily drilled, a drilling machine may obtain the image, and analyze the image to obtain a position of a primary drilled hole, to perform secondary drilling. A specific form of the traceability information 12 is not limited, and may be a bar code, a two-dimensional code, or may be a plain code. The plain code is number information (ID code).

Step S204: Mount the structure 11 to be secondarily drilled on a workbench of the drilling machine.

Step S205: A second control unit reads the traceability information 12, and obtains the image corresponding to the current structure 11 to be secondarily drilled.

Step S206: The second control unit obtains, based on the image, system hole position coordinates of a primary drilled hole needing to be secondarily drilled in the drilling machine.

Step S207: The second control unit controls, based on the system hole position coordinates, a main shaft 20 of the drilling machine to perform secondary drilling on the primary drilled hole of the structure 11 to be secondarily drilled.

In this procedure, a part that is the same as that in an embodiment corresponding to FIG. 5 is not described in detail herein.

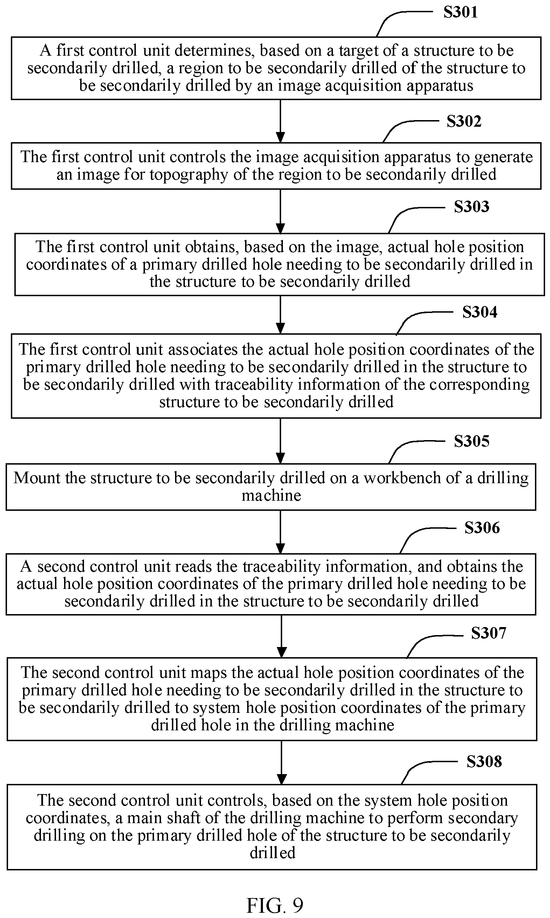

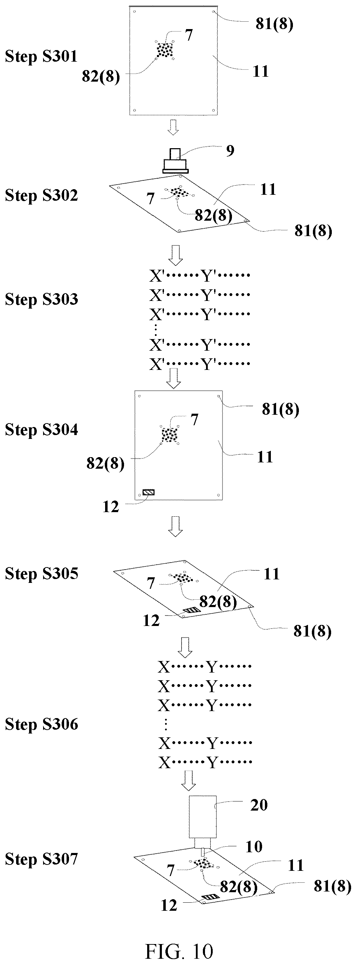

FIG. 9 is another flowchart of a secondary drilling process according to an embodiment of this application. FIG. 10 is another flowchart of a structure of secondary drilling according to an embodiment of this application. As shown in FIG. 9 and FIG. 10, a procedure of the secondary drilling process includes the following steps.

Step S301: A first control unit determines, based on a target 8 of a structure 11 to be secondarily drilled, a region 7 to be secondarily drilled of the structure 11 to be secondarily drilled by an image acquisition apparatus 9.

Step S302: The first control unit controls the image acquisition apparatus 9 to generate an image for topography of the region 7 to be secondarily drilled.

Step S303: The first control unit obtains, based on the image, actual hole position coordinates of a primary drilled hole needing to be secondarily drilled in the structure 11 to be secondarily drilled.

Step S304: The first control unit associates the actual hole position coordinates of the primary drilled hole needing to be secondarily drilled in the structure 11 to be secondarily drilled with traceability information 12 of the corresponding structure 11 to be secondarily drilled.

Step S305: Mount the structure 11 to be secondarily drilled on a workbench of a drilling machine.

Step S306: A second control unit reads the traceability information 12, and obtains the actual hole position coordinates of the primary drilled hole needing to be secondarily drilled of the structure 11 to be secondarily drilled in the structure 11 to be secondarily drilled.

Step S307: The second control unit maps the actual hole position coordinates of the primary drilled hole needing to be secondarily drilled in the structure 11 to be secondarily drilled to system hole position coordinates of the primary drilled hole in the drilling machine.

The actual hole position coordinates of the primary drilled hole needing to be secondarily drilled in the structure 11 to be secondarily drilled may be determined based on the target 8 of the structure 11 to be secondarily drilled. Specifically, a coordinate system may be established based on the target 8 of the structure 11 to be secondarily drilled, and the actual hole position coordinates of the primary drilled needing to be secondarily drilled in the structure 11 to be secondarily drilled may be coordinates of the primary drilled hole in the coordinate system. After the structure 11 to be secondarily drilled is mounted on the workbench of the drilling machine, the drilling machine may form a mapping relationship between the coordinate system of the structure 11 to be secondarily drilled and a coordinate system of the drilling machine by reading a relationship between the target 8 of the structure 11 to be secondarily drilled and the coordinate system of the drilling machine. Through the mapping relationship, the system hole position coordinates of the primary drilled hole in the drilling machine may be calculated by using the actual hole position coordinates of the primary drilled hole needing to be secondarily drilled in the structure 11 to be secondarily drilled.

Step S308: The second control unit controls, based on the system hole position coordinates, a main shaft 20 of the drilling machine to perform secondary drilling on the primary drilled hole of the structure 11 to be secondarily drilled.

In this procedure, a part that is the same as that in an embodiment corresponding to FIG. 5 and FIG. 7 is not described in detail herein. It should be noted that, a difference between this embodiment and an embodiment corresponding to FIG. 7 lies in that, in this embodiment, the first control unit of the offline measuring machine is used to analyze the image, to obtain the actual hole position coordinates of the primary drilled hole needing to be secondarily drilled in the structure 11 to be secondarily drilled based on the image; and the actual hole position coordinates of the primary drilled hole needing to be secondarily drilled in the structure 11 to be secondarily drilled are associated with the traceability information 12 of the structure 11 to be secondarily drilled, so that the second control unit of the drilling machine can directly read the actual hole position coordinates of the primary drilled hole needing to be secondarily drilled in the structure 11 to be secondarily drilled, thereby further improving work efficiency of the drilling machine

When the foregoing secondary drilling process is specifically applied, the foregoing structure 11 to be secondarily drilled may be a circuit board, and the secondary drilling may be back drilling. In other words, back drilling of the circuit board is implemented by the foregoing secondary drilling process, to improve back drilling precision of the circuit board, and improve wiring density inside the circuit board, thereby helping meet a high density requirement of the circuit board.

The foregoing descriptions are merely specific implementations of this application, but are not intended to limit a protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A secondary drilling process, wherein the process comprises:
determining, by a controller based on a target of a structure to be secondarily drilled, a position of a region to be secondarily drilled of the structure to be secondarily drilled by an image acquisition apparatus;
controlling, by the controller, the image acquisition apparatus to generate an image for topography of the region to be secondarily drilled;
obtaining, by the controller, the image, and obtaining actual hole position coordinates of a primary drilled hole needing to be secondarily drilled based on the image; and
controlling, by the controller based on the actual hole position coordinates, a main shaft of a drilling machine to perform secondary drilling on the primary drilled hole needing to be secondarily drilled of the structure to be secondarily drilled.

2. The secondary drilling process according to claim 1, wherein the image acquisition apparatus and the controller are disposed on the drilling machine; and
before the determining, by a controller based on a target of a structure to be secondarily drilled, a position of a region to be secondarily drilled of the structure to be secondarily drilled, the process comprises:
mounting the structure to be secondarily drilled on a workbench of the drilling machine.

3. The secondary drilling process according to claim 1, wherein a drilling device further comprises an offline measuring machine, and the controller comprises a first control unit and a second control unit; the first control unit is signally connected to the image acquisition apparatus, and the first control unit and the image acquisition apparatus are disposed on the offline measuring machine; and the second control unit is signally connected to the drilling machine, and the second control unit is disposed on the drilling machine.

4. The secondary drilling process according to claim 3, wherein the process specifically comprises:
determining, by the first control unit based on the target of the structure to be secondarily drilled, the region to be secondarily drilled of the structure to be secondarily drilled by the image acquisition apparatus;
controlling, by the first control unit, the image acquisition apparatus to generate the image for the topography of the region to be secondarily drilled;
associating, by the first control unit, the image with traceability information of the corresponding structure to be secondarily drilled;
mounting the structure to be secondarily drilled on a workbench of the drilling machine;
reading, by the second control unit, the traceability information, and obtaining the image corresponding to the current structure to be secondarily drilled;
obtaining, by the second control unit based on the image, system hole position coordinates of the primary drilled hole needing to be secondarily drilled in the drilling machine; and
controlling, by the second control unit based on the system hole position coordinates, the main shaft of the drilling machine to perform secondary drilling on the primary drilled hole needing to be secondarily drilled of the structure to be secondarily drilled.

5. The secondary drilling process according to claim 3, wherein the process specifically comprises:
determining, by the first control unit based on the target of the structure to be secondarily drilled, the region to be secondarily drilled of the structure to be secondarily drilled by the image acquisition apparatus;
controlling, by the first control unit, the image acquisition apparatus to generate the image for the topography of the region to be secondarily drilled;
obtaining, by the first control unit based on the image, the actual hole position coordinates of the primary drilled hole needing to be secondarily drilled in the structure to be secondarily drilled;
associating, by the first control unit, the actual hole position coordinates with traceability information of the corresponding structure to be secondarily drilled;
mounting the structure to be secondarily drilled on a workbench of the drilling machine;
reading, by the second control unit, the traceability information, and obtaining the actual hole position coordinates of the current structure to be secondarily drilled;
mapping, by the second control unit, the actual hole position coordinates to system hole position coordinates of the primary drilled hole needing to be secondarily drilled in the drilling machine; and
controlling, by the second control unit based on the system hole position coordinates, the main shaft of the drilling machine to perform secondary drilling on the primary drilled hole needing to be secondarily drilled of the structure to be secondarily drilled.

6. The secondary drilling process according to any one of claims 3 to 5, wherein the traceability information comprises a bar code, a two-dimensional code, or number information.

7. The secondary drilling process according to any one of claims 1 to 6, wherein the target comprises an edge target and a target of the region to be secondarily drilled, wherein the edge target is located at an edge of the structure to be secondarily drilled, and the target of the region to be secondarily drilled is located on a peripheral side of the region to be secondarily drilled.

8. The secondary drilling process according to any one of claims 1 to 7, wherein the image acquisition apparatus comprises a lens or a two-dimensional scanner.

9. The secondary drilling process according to any one of claims 1 to 8, wherein the structure to be secondarily drilled is a circuit board, and the secondary drilling process is a back drilling process.

10. The secondary drilling process according to any one of claims 1 to 9, wherein before the determining, by a controller based on a target of a structure to be secondarily drilled, a position of a region to be secondarily drilled of the structure to be secondarily drilled by an image acquisition apparatus, the process comprises:
making the target on the structure to be secondarily drilled, or defining the target on the structure to be secondarily drilled.
